Europäisches Patentamt

European Patent Office

Office européen des brevets

(19)

(11) **EP 1 717 949 A1**

(12) **EUROPEAN PATENT APPLICATION**

(43) Date of publication:
 **02.11.2006 Bulletin 2006/44**

(51) Int Cl.:
 **H03F 1/32** (2006.01)

(21) Application number: **05008778.2**

(22) Date of filing: **21.04.2005**

(84) Designated Contracting States:
 **AT BE BG CH CY CZ DE DK EE ES FI FR GB GR
 HU IE IS IT LI LT LU MC NL PL PT RO SE SI SK TR**
 Designated Extension States:
 **AL BA HR LV MK YU**

(71) Applicant: **SIEMENS AKTIENGESELLSCHAFT
 80333 München (DE)**

(72) Inventor: **Langer, Andreas
 85716 Unterschleissheim-Lohhof (DE)**

(54) **Method and apparatus for reducing nonlinear distortions in generating a high frequency signal**

(57)    In a method and an apparatus for reducing nonlinear distortions in generating a high frequency signal, based on a closed loop control type pre-distortion of the input signal of a power amplifier (PA), the high frequency analog output signal (Out(t)) of said power amplifier is converted (ADC) into the digital base band. There a difference signal (D) is formed between the converted output signal (Vab(t)) and a suitably time-delayed base band signal (Vm(t)). This difference signal is used for a pre-distortion of this input signal (Vm(t)), characterized by a Fourier transformation (FFT) of the difference signal, a calculation (AF) of a filter characteristic of a digital filter (DF) and a filtering of the input signal with help of this digital filter.

FIG 4

**Description**

In connection with modulation procedures with a non-constant (i.e. varying) envelope, e.g. HPSK as used in the UMTS-standard, usually a linear power amplifier is required to avoid nonlinear distortions of the envelope. Such nonlinear distortions among others lead to an increase in adjacent channel power, the so called "spectral re-growth". This is undesirable because other subscribers might be disturbed by spurious signals.

In various cellular communication standards precisely defined requirements have been defined for the maximally tolerable adjacent channel power. These requirements can frequently only be met with significant effort on the transmitter side.

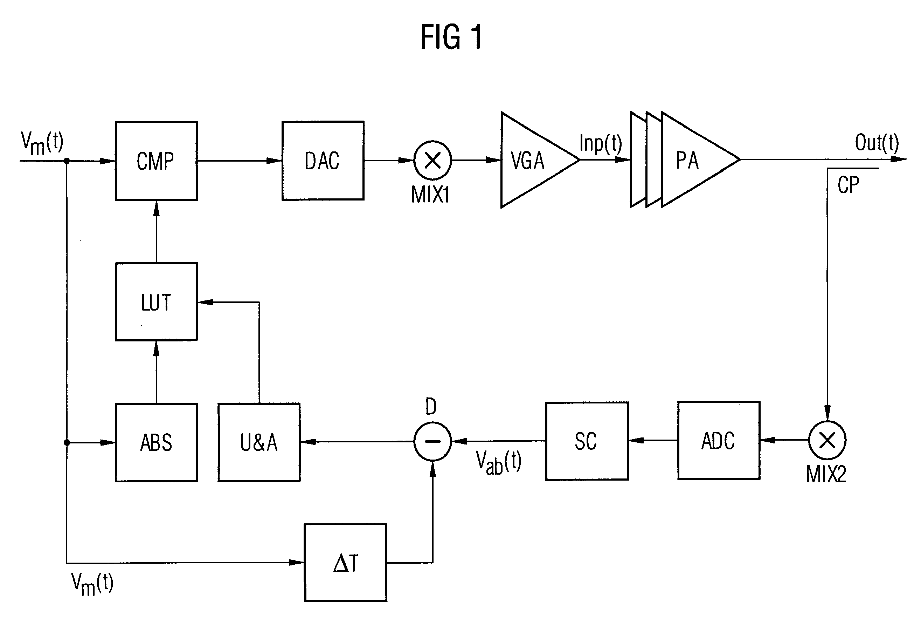

Various approaches are known for the linearization of the characteristic of a power amplifier, which is a slightly imprecise way to say that various circuitry has been designed around a power amplifier to achieve a less nonlinear behaviour of the whole system (power amplifier plus additional circuitry). Roughly the skilled person differentiates between feedback, feed forward and pre-distortion methods. Among the pre-distortion methods an important class is the so called digital base band pre-distortion. Figure 1 shows a typical case of such a method and corresponding circuitry. In accordance with and depending on the current input amplitude a value (ABS) is read out of the LUT and is multiplied (CMP) - according to the rules of complex number multiplication - with the base band signal $V_m(t)$. As a result of this complex multiplication (CMP), the signal $V_m(t)$ is pre-distorted in amplitude and phase. The adaptation of the LUT is done by a comparison of the transmission signal $V_{ab}(t)$ with the input signal $V_m(t)$. The delay between $V_{ab}(t)$ and $V_m(t)$ has to be rather small, e.g. smaller than 4 ns in WCDMA. This requires an additional time delay estimation, since the delay strongly depends on temperature, frequency, power supply voltage etc.

A disadvantage of such known methods and systems is that memory effects in the power amplifier cannot be compensated, because the values stored in the LUT are produced according to amplitudes and phases of the sample values but without regard to the current frequency of the envelope. The term memory effect here refers to the dependence of the AM/AM and AM/PM conversion on the current frequency of the envelope, which cause a dependence of the nonlinearity on the current data sequence.

The present invention therefore aims to contribute to an improvement of the reduction of any increase of the adjacent channel power that may be caused be the nonlinear characteristics of real (i.e. non-ideal) power amplifiers used for the generation of a high frequency signal. This is achieved by a method and / or apparatus according to one of the claims.

In the following, the invention is disclosed in detail with reference to figures and by help of preferred embodiments.

Figure 1 shows a schematic model to illustrate the cancellation of nonlinearities by digital pre-distortion according to the prior art.

Figure 2 shows a schematic illustration of a model for the description of the way pre-distortion works.

Figure 3 shows a model to describe pre-distortion with complex base band filtering.

Figure 4 shows a schematic model to illustrate the cancellation of nonlinearities according to the present invention.

The present invention is based on an additive spectral shaping of the pre-distorted base band signal in the frequency domain and aims at an improvement of the linearization (i.e. reduction of nonlinear distortions) in systems with high bandwidth, e.g. UMTS and forthcoming cellular radio standards like 4G, etc.).

The present invention differs from the prior art essentially in an additional filtering of the pre-distorted base band signal with the goal to reduce existing frequency dependent nonlinearities by compensation. The filter is preferably implemented as a digital filter with a frequency characteristic that can be adjusted with respect to absolute value (amplitude) and phase. The frequency characteristic of the filter can be static (i.e. time-independent) e.g. stored in a fixed memory or it can be determined by adaptation according to a preferred embodiment of the present invention.

In the first case (i.e. static filter characteristic) it will in many cases be advantageous to let the filter characteristic be dependent on parameters like the temperature or the carrier frequency, etc.

The present invention is based on the assumption that the (real, i.e. non-ideal) power amplifier (PA) operates with a not completely or exactly linear characteristic, but that there are non-negligible nonlinear contributions, that are regarded to be unavoidable to a certain extend in any real amplifier. Mathematically this means that the output signal (out(t)) is a nonlinear functional (NLF) of the input signal (inp(t)), which may be assumed to be expandable into a functional power series (a so called Volterra series) e.g. of the type

(1)

$$out(t) = NLF[inp](t) = \int_0^t dt' h(t-t') \cdot inp(t') + \int_0^t dt' \int_0^{t'} dt'' h(t-t',t-t'') \cdot inp(t') \cdot inp(t'')$$

$$+ \int_0^t dt' \int_0^{t'} dt'' \int_0^{t''} dt''' h(t-t',t-t'',t-t''') \cdot inp(t') \cdot inp(t'') \cdot inp(t''') + ...(higher \quad order \quad terms)$$

In the important case of an input signal that is a superposition of two harmonic parts at frequencies $\omega_1$ and $\omega_2$ with complex amplitudes $V_1$ and $V_2$, this yields - in the case of "weak" saturation - an inter-modulation product at frequency $2 \cdot \omega_1 - \omega_2$, namely

$$\frac{3}{4} V_1 V_1 V_2^* G_3(\omega_1,\omega_1,-\omega_2) \cdot H_1(2\omega_1 - \omega_2) + \frac{3}{4} V_1 V_1 V_2^* G_1(\omega_1) \cdot G_1(\omega_1) \cdot G_1^*(\omega_2) \cdot H_3(\omega_1,\omega_1,-\omega_2)$$

(2)

In this frequency domain description, the so called Volterra operators $H_1$ and $H_3$ correspond to the linear (1st order) and cubic (3rd order) terms in equ. 1 above. They are fourier transforms of the memory functions (convolution kernels) h(t) and h(t,t',t'') in equation 1. This way, AM/PM- conversion can be described as well as memory effects.

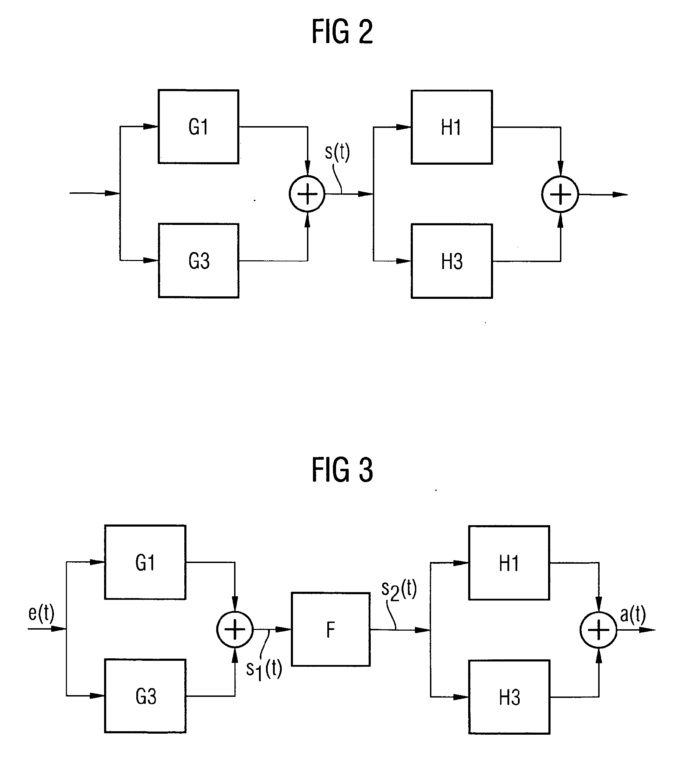

Figure 2 shows a model of pre-distortion, in which the operators G1 and G3 are introduced to compensate for the frequency dependence of the nonlinearity of the power amplifier. In order to achieve cancellation of nonlinear terms, G3 would have to be chosen according to equ. 3 as

(3)
$$G_3(\omega_1,\omega_1,-\omega_2) = \frac{G_1(\omega_1) \cdot G_1(\omega_1) \cdot G_1^*(\omega_2) \cdot H_3(\omega_1,\omega_1,-\omega_2)}{H_1(2\omega_1 - \omega_2)}$$

One can see from equation 3 that G3 has to be frequency dependent in order to be able to compensate for the frequency dependence of the nonlinearity of the power amplifier. On the other hand, the pre-distortion according to figure 1 can not meet this requirement, because the values stored in the LUT - which contains G3 implicitly - are independent of the frequency.

In connection with modulation methods with high bandwidth this means that the phase and amplitude conditions for a cancellation cannot be met over the complete bandwidth, because the frequency dependence of the nonlinearity cannot be neglected over the whole bandwidth. On the other hand, these conditions must be met precisely. For example, as the skilled person knows, the cancellation of two sinusoids (of amplitude one) is as poor as -15 dB if the phase difference reaches only 10° (10 degrees). To achieve a sufficient cancellation over the complete modulation bandwidth, the inter-modulation products generated in the pre-distortion have to be added in proper phase to the nonlinearities generated in the power amplifier.

The current invention improves this situation by suggesting a method and a corresponding apparatus which guarantees a sufficient cancellation of inter-modulation products over the complete relevant band width in spite of the memory effects in the amplifier.

According to the current invention, a Filter F is introduced into the signal path according to figure 3, the frequency dependence $F(\omega)$ of which filter F will be explained during the following disclosure.

To this end, equation 2 is generalized to the case of a continuous spectrum. For the inter-modulation product $IMD(\omega)$ between $\omega_g$ and $\omega_{2g}$ the equation

(4)

$$IMD(\omega) = \frac{3}{4} \int_{\frac{\omega}{2}}^{\omega_g} A(\omega') \cdot A(\omega') \cdot A^*(2\omega'-\omega) \cdot G_3 \cdot H_1(\omega) \cdot F(\omega) d\omega'$$

$$+ \frac{3}{4} \int_{\frac{\omega}{2}}^{\omega_g} A(\omega') \cdot A(\omega') \cdot A^*(2\omega'-\omega) \cdot G_1 \cdot G_1 \cdot G_1^* \cdot F(\omega') \cdot F(\omega') \cdot F^*(2\omega'-\omega) \cdot H_3(\omega',\omega',-(2\omega'-\omega)) d\omega'$$

holds.

In this equation, $A(\omega)$ designates a phasor which is generated by evaluation of the amplitude spectrum at frequency $\omega$. In case the base band signal is at the same time phase and amplitude modulated, the complete spectrum is calculated by a convolution of the distorted amplitude spectrum with the phase spectrum. $\omega_g$ designates the fundamental frequency of the modulating process; G1 and G3 are assumed to be frequency independent.

To proceed with the calculation it is assumed - only for presenting the current argument, not as a prerequisite for the invention, which is of far more general applicability - that the operator H3 - i.e. the amplitude and phase - depends linearly on frequency, i.e.

$$(5) \qquad H_3(\omega) = H_{3,0} \cdot (1 + a \cdot \omega) \cdot e^{jb\omega}$$

The operator G3 is assumed to be determined, for example, by way of adaptation according to figure 1 (G3 does not exist explicitly in this arrangement but is contained implicitly in the LUT) .

Equation 4 then assumes the special form

(6)

$$IMD(\omega) = \frac{3}{4} \int_{\frac{\omega}{2}}^{\omega_g} A(\omega') \cdot A(\omega') \cdot A^*(2\omega'-\omega) \cdot G_3 \cdot H_1(\omega) \cdot F(\omega) d\omega'$$

$$+ \frac{3}{4} \int_{\frac{\omega}{2}}^{\omega_g} A(\omega') \cdot A(\omega') \cdot A^*(2\omega'-\omega) \cdot G_1 \cdot G_1 \cdot G_1^* \cdot F(\omega') \cdot F(\omega') \cdot F^*(2\omega'-\omega) \cdot H_{3,0} \cdot (1 + a \cdot \omega') \cdot e^{jb\omega'} d\omega'$$

$F(\omega')$ and $F^*(2\omega'-\omega)$ are in the frequency region between 0 and $\omega_g$. The frequency characteristic of this filter can be chose equal to 1 in this in-band region, since only the region between $\omega_g$ and $2\omega_g$ is considered here (since the measurements of ACLR are done here in UMTS). This in-band region moreover contains the desired modulation and its spectrum should therefore not be changed anyway. If one now chooses

$$(7) \qquad F(\omega) = \frac{G_1 \cdot G_1 \cdot G_1^* \cdot H_{3,0} \cdot (1 + a \cdot \omega) \cdot e^{jb\omega}}{H_1(\omega) \cdot G_3}$$

the inter-modulation product vanishes in spite of the frequency dependence of H1 and H3. How can the frequency characteristic of the filter be determined?

One possibility would be to store the filter characteristic in a static manner (possibly depending on temperature and carrier frequency) in a suitable storage means. The frequency characteristic could in this case be determined e.g. in a laboratory or even in the production line.

A further and more preferable procedure will be suggested in the following. To this end, equ. 6 will be solved in a discrete manner. With $\omega_g = N \cdot \Delta f$, $\omega = n \cdot \Delta f$ and $\omega' = i \cdot \Delta f$ equ. 6 yields

$$(8) \quad IMD(n) = \frac{3}{4} \sum_{i=\frac{n}{2}}^{N} A(i)A(i)A^*(2i-n)\left[G_3 H_1(n)F(n) + G_1 G_1 G_1^* H_{3,0}(1+an)e^{jbn}\right]\Delta f$$

For n=2N, for example, this reduces to

$$(9) \quad IMD(2N) = \frac{3}{4} A(N)A(N)A^*(0)\left[G_3 H_1(2N)F(2N) + G_1 G_1 G_1^* H_{3,0}(1+2aN)e^{2jbN}\right]\Delta f$$

F(2N) is now varied until IMD(2N) vanishes. Subsequently the value for F(2N-2) is calculated and so on for F(2N-i). Preferably this is done according to the following description.

In practice H1 and H3 are of course unknown. For this reason, equ. 8 can not be solved explicitly. As explained above, the filter characteristic can, however, be determined recursively with the help of control points. After each variation of a value for F(n) however, IMD(n) has to be measured again. This is a typical feature of all pre-distortion methods in which the effect of a changed filter characteristic or an adapted LUT on the system can only be detected by a measurement, because the nonlinearities of the amplifier are neither known explicitly nor modelled with sufficient precision.

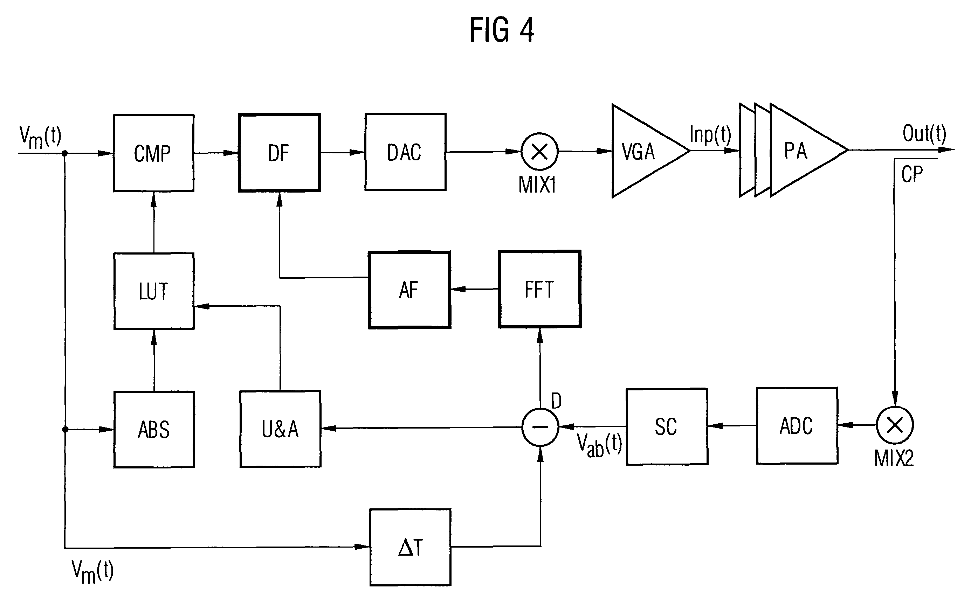

Figure 4 shows a schematic model to illustrate the cancellation of nonlinearities according to the present invention and the general architecture of an apparatus implementing a preferred embodiment of the invention.

The base band signal Vm(t) is multiplied in the complex domain (CMP) (i.e. according to the rules of complex number multiplication) with values read out of an LUT, which is addressed by way of amplitude values (ABS) and an updated and adapted (U&A) form of the difference signal (D). This difference signal (D) is calculated from a scaled (SC) and analog-to-digital converted (ADC) signal which comes from a Mixer (MIX2) which transforms the output signal (Out (t)) of the power amplifier (PA) into the base band domain. A delay-time estimation (AT) is used to take suitably account of unavoidable time delays in the feedback loop.

After the complex multiplication (CMP) with the LUT-values, Vm(t) is processed by the digital filter (DF). The filter characteristic of this filter has been determined by an adaptation process (AF) on the basis of the Fourier transformed difference signal (D).

The main differences to figure 1 are emphasized graphically as bold-framed boxes. The difference signal D is (preferably fast) Fourier transformed (FFT) and subsequently used (AF) to determine the filter characteristic of the digital filter (DF). To this end, first the required filter characteristic is determined at discrete control points. From these values the complete frequency characteristic can be determined by interpolation. The frequency characteristic of the digital Filter (DF) has to be adaptable (AF) with respect to phase and amplitude at least in the frequency region between $\omega_g$ and $2\omega_g$. In the in-band region, preferably a filter characteristic equal to 1 (constant, not frequency dependent, i.e. "no" filtering) is chosen.

For the determination of the filter characteristic the following method may be preferred:

First, the LUT is calculated with a known, constant filter characteristic. After that, in a second step, the optimization in the frequency domain is done. With a constant LUT, the filter characteristic is varied until the error in the frequency domain decreased below a given value. The classical pre-distortion method has thus been amended and extended by an additional optimization in the frequency domain, so that especially in connection with modulation methods with high bandwidth for 3rd and 4th generation cellular systems an improved cancellation is achieved over the whole relevant frequency domain (i.e. between $\omega_g$ and $2\omega_g$).

List of Reference Symbols

| PA | Power Amplifier |
| VGA | Pre-Amplifier |
| LUT | Storage means, look up table |
| MIX1, MIX2 | Mixer 1, Mixer 2 |

| DAC | Digital-to-Analog Converter |
| --- | --- |
| ADC | Analog-to-Digital Converter |
| PRED | Pre-Distortion |
| DF | Digital Filter |
| CP | Coupler |
| DEM | Demodulator |
| TRXF | Transmission Filter |
| FFT | Fast Fourier Transformation |
| AF | Calculation of the Filter Characteristic |
| CMP | Complex multiplication |
| ABS | amplitude, absolute value of a signal |
| U&A | Update and Adaptation |
| SC | Scaling of a signal |

**Claims**

1. Method for reducing nonlinear distortions in generating a high frequency signal, which method is based on a closed loop control type pre-distortion of the input signal of a power amplifier (PA), in which the high frequency analog output signal (Out(t)) of said power amplifier is converted (ADC) into the digital base band where a difference signal (D) is formed between the converted output signal (Vab(t)) and a suitably time-delayed base band signal (Vm(t)), and in which this difference signal is used for a pre-distortion of this input signal (Vm(t)), **characterized by** a Fourier transformation (FFT) of the difference signal, a calculation (AF) of a filter characteristic of a digital filter (DF) and a filtering of the input signal with help of this digital filter.

2. Method according to claim 1, in which the filter characteristic of the filter (DF) is calculated by an adaptation process (AF) which optimizes the cancellation of inter-modulation products occurring in the output signal (Out(t)) as a result of nonlinear characteristics of the power amplifier (PA).

3. Apparatus for reducing nonlinear distortions in generating a high frequency signal, comprising a closed loop control type pre-distortion of the input signal of a power amplifier (PA), in which the high frequency analog output signal (Out(t)) of said power amplifier is converted (ADC) into the digital base band where a difference signal (D) is formed between the converted output signal (Vab(t)) and a suitably time-delayed base band signal (Vm(t)), and in which this difference signal is used for a pre-distortion of this input signal (Vm(t)), **characterized by** a Fourier transformation (FFT) of the difference signal, a calculation (AF) of a filter characteristic of a digital filter (DF) and a filtering of the input signal with help of this digital filter.

FIG 1

## FIG 2

## FIG 3

FIG 4

**European Patent Office**

## EUROPEAN SEARCH REPORT

Application Number

EP 05 00 8778

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 2003/080814 A1 (ODE TAKAYOSHI ET AL) 1 May 2003 (2003-05-01) * paragraph [0059]; figures 9,13 * ----- | 1-3 | H03F1/32 |
| A | US 2003/184372 A1 (FUDABA NOBUKAZU ET AL) 2 October 2003 (2003-10-02) * paragraph [0096] - paragraph [0098]; figure 1 * ----- | 1-3 | |
| A | EP 1 499 027 A (FUJITSU LIMITED) 19 January 2005 (2005-01-19) * paragraph [0072]; figures 20,21 * ----- | 1-3 | |
| A | US 6 697 436 B1 (WRIGHT ANDREW S ET AL) 24 February 2004 (2004-02-24) * column 35, line 37 - column 36, line 44; figures 23,25 * ----- | 1-3 | |
| A | US 5 912 586 A (MITZLAFF ET AL) 15 June 1999 (1999-06-15) * figure 2 * ----- | 1 | |
| A | US 2004/246048 A1 (LEYONHJELM SCOTT ET AL) 9 December 2004 (2004-12-09) * paragraph [0081]; figure 1 * ----- | 1 | TECHNICAL FIELDS SEARCHED (Int.Cl.7) H03F |
| A | EP 1 463 198 A (NTT DOCOMO, INC) 29 September 2004 (2004-09-29) * paragraph [0024]; figures 5a,5b * ----- | 1 | |

The present search report has been drawn up for all claims

| Place of search | Date of completion of the search | Examiner |
|---|---|---|
| Munich | 29 June 2005 | Kurzbauer, W |

**ANNEX TO THE EUROPEAN SEARCH REPORT
ON EUROPEAN PATENT APPLICATION NO.**

EP 05 00 8778

This annex lists the patent family members relating to the patent documents cited in the above-mentioned European search report.
The members are as contained in the European Patent Office EDP file on
The European Patent Office is in no way liable for these particulars which are merely given for the purpose of information.

29-06-2005

| Patent document cited in search report | | Publication date | Patent family member(s) | | Publication date |
|---|---|---|---|---|---|
| US 2003080814 | A1 | 01-05-2003 | JP | 2003142959 A | 16-05-2003 |
| US 2003184372 | A1 | 02-10-2003 | JP | 2003298362 A | 17-10-2003 |
| EP 1499027 | A | 19-01-2005 | WO | 03103163 A1 | 11-12-2003 |
| | | | EP | 1499027 A1 | 19-01-2005 |
| | | | US | 2005047521 A1 | 03-03-2005 |
| US 6697436 | B1 | 24-02-2004 | AU | 6309300 A | 13-02-2001 |
| | | | EP | 1196988 A1 | 17-04-2002 |
| | | | WO | 0108294 A1 | 01-02-2001 |
| | | | AT | 276604 T | 15-10-2004 |
| | | | AT | 276602 T | 15-10-2004 |
| | | | AT | 276603 T | 15-10-2004 |
| | | | AU | 5840500 A | 13-02-2001 |
| | | | AU | 5840800 A | 13-02-2001 |
| | | | AU | 6009300 A | 13-02-2001 |
| | | | AU | 6009400 A | 30-01-2001 |
| | | | DE | 60013851 D1 | 21-10-2004 |
| | | | DE | 60013852 D1 | 21-10-2004 |
| | | | DE | 60013856 D1 | 21-10-2004 |
| | | | EP | 1205024 A1 | 15-05-2002 |
| | | | EP | 1203444 A1 | 08-05-2002 |
| | | | EP | 1196986 A2 | 17-04-2002 |
| | | | EP | 1203445 A1 | 08-05-2002 |
| | | | EP | 1280273 A2 | 29-01-2003 |
| | | | WO | 0108295 A1 | 01-02-2001 |
| | | | WO | 0108296 A1 | 01-02-2001 |
| | | | WO | 0105026 A1 | 18-01-2001 |
| | | | WO | 0108297 A1 | 01-02-2001 |
| | | | US | 6587514 B1 | 01-07-2003 |
| | | | US | 6798843 B1 | 28-09-2004 |
| | | | US | 6356146 B1 | 12-03-2002 |
| | | | US | 6342810 B1 | 29-01-2002 |
| | | | US | 2002008578 A1 | 24-01-2002 |
| | | | US | 2002044014 A1 | 18-04-2002 |
| | | | US | 2001050592 A1 | 13-12-2001 |
| US 5912586 | A | 15-06-1999 | CA | 2314108 A1 | 01-07-1999 |
| | | | CN | 1283326 A ,C | 07-02-2001 |
| | | | EP | 1040569 A1 | 04-10-2000 |
| | | | JP | 2001527311 T | 25-12-2001 |
| | | | WO | 9933167 A1 | 01-07-1999 |
| US 2004246048 | A1 | 09-12-2004 | CN | 1550064 A | 24-11-2004 |
| | | | EP | 1425849 A1 | 09-06-2004 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 05 00 8778

This annex lists the patent family members relating to the patent documents cited in the above-mentioned European search report.
The members are as contained in the European Patent Office EDP file on
The European Patent Office is in no way liable for these particulars which are merely given for the purpose of information.

29-06-2005

| Patent document cited in search report | Publication date | Patent family member(s) | | Publication date |
|---|---|---|---|---|
| US 2004246048 A1 | | WO | 03019773 A1 | 06-03-2003 |
| EP 1463198 A | 29-09-2004 | JP | 2004289504 A | 14-10-2004 |
| | | CN | 1533028 A | 29-09-2004 |
| | | EP | 1463198 A2 | 29-09-2004 |
| | | US | 2004189378 A1 | 30-09-2004 |

EPO FORM P0459

For more details about this annex : see Official Journal of the European Patent Office, No. 12/82